# EUROPEAN PATENT APPLICATION

(11) **EP 4 632 972 A2**
(43) Date of publication of application: **15.10.2025**
(21) Application number: 25167370.3
(22) Date of filing: 31.03.2025
(51) Int. Cl.: H01S 5/42, H01S 5/183

(54) **ADDRESSABLE VERTICAL-CAVITY SURFACE-EMITTING LASER ILLUMINATOR**

(30) Priority: 09.04.2024 US 202418630657
(71) Applicant: B.E. Meyers & Co., Inc., Redmond, WA 98052 (US)
(72) Inventor: Nelson, Spencer, Redmond, WA, 98052 (US); Elledge, Miles, Redmond, WA, 98052 (US); Bigby, Alexander, Redmond, WA, 98052 (US); Alldredge, Thomas, Redmond, WA, 98052 (US)
(74) Representative: Grünecker Patent- und Rechtsanwälte PartG mbB

(57) **Abstract**

A vertical-cavity surface-emitting laser (VCSEL) illuminator system includes a VCSEL die positioned perpendicular to an optical axis of a lens, the VCSEL die including respective emitter elements positioned within respective spatial zones of an emission surface of the VCSEL die, where a distance between the lens and the emission surface of the VCSEL die differs from a focal length of the lens; a diffuser situated opposite the VCSEL die with respect to the lens, resulting in an optical path of light emitted from the VCSEL die passing through the lens and the diffuser; a controller that selects emitter elements, of the emitter elements, based on an intended angular beam width of light to be emitted from the system; and a driver system that selectively applies a drive signal to the selected emitter elements in response to the selected emitter segments, elements, or zones being selected by the controller.

## Description

### BACKGROUND

In conditions in which an operator is equipped with a night vision device (NVD) and an illumination device, e.g., an infrared (IR) illumination device, the operator may in some cases desire additional illumination to increase the amount of information available from the NVD. Such an increase in illumination can be achieved, e.g., by adjusting the output divergence and output power of the illumination device. In conventional illumination devices, these adjustments are typically performed based on physical movement of an optical element relative to the position of an optical source, e.g., to adjust the focus of the device. For example, a lens can be rotated within a threaded bezel to adjust focus. Alternatively, a linear stage or other mechanical means can be employed to vary focus.

### SUMMARY

The following summary is a general overview of various embodiments disclosed herein and is not intended to be exhaustive or limiting upon the disclosed embodiments. Embodiments are better understood upon consideration of the detailed description below in conjunction with the accompanying drawings and claims.

In an implementation, a system is described herein. The system can include a vertical-cavity surface-emitting laser (VCSEL) die positioned perpendicular to an optical axis of a lens. The VCSEL die can include respective emitter elements positioned within respective spatial zones of an emission surface of the VCSEL die, and a distance between the lens and the emission surface of the VCSEL die can, but need not, differ from a focal length of the lens by at least a threshold amount. The system can further include a diffuser object situated opposite the VCSEL die with respect to the lens, resulting in an optical path of light emitted from the VCSEL die passing through the lens and the diffuser object. The system additionally includes a controller that selects emitter elements, of the of the emitter elements and positioned within respective selected spatial zones of the spatial zones, based on an intended angular beam width of light to be emitted from the system, resulting in selected emitter elements. The system also includes a driver system that selectively applies a drive signal to the selected emitter elements in response to the selected emitter elements being selected by the controller.

In another implementation, another system is described herein. The system can include a VCSEL die that includes VCSEL emitters arranged on respective regions of an emission surface of the VCSEL die, the VCSEL emitters including respective groups of one or more lasing segments etched into the emission surface of the VCSEL die. The system can also include an optics system situated within an optical path of light emitted from the emission surface of the VCSEL die, the optics system including a lens and a diffractive optical element situated opposite the VCSEL die with respect to the lens, where a distance between the lens and the VCSEL die can, but need not, differ from a focal length of the lens by at least a threshold amount. The system can further include a control system that energizes selected ones of the VCSEL emitters based on a selection input, resulting in selected VCSEL emitters and causing light emitted from the selected VCSEL emitters to leave the optics system at an intended target angular beam width associated with the selection input.

In an additional implementation, a method is described herein. The method can include selecting, by a system including a processor, one or more elements from elements of a vertical-cavity surface-emitting laser (VCSEL) die of an illuminator device based on a selection input, resulting in one or more selected elements of the VCSEL array, where the selection input is indicative of a selectable angular beam width of light to be emitted from the illuminator device. Additionally, the method can include driving, by the system, the one or more selected elements of the VCSEL array, resulting in the one or more selected elements of the VCSEL array emitting the light through a lens and a diffuser, where the lens is positioned at a distance from the VCSEL array that can, but need not, differ from a focal length of the lens, and further resulting in the light being emitted from the illuminator device at the angular beam width.

### DESCRIPTION OF DRAWINGS

Various non-limiting embodiments of the subject disclosure are described with reference to the following figures, wherein like reference numerals refer to like parts throughout unless otherwise specified.
FIG. 1 is a block diagram of a system that facilitates illumination via an addressable vertical-cavity surface-emitting laser (VCSEL) illuminator in accordance with various implementations described herein.
FIG. 2 is a diagram depicting a front view of the emission surface of the VCSEL die of FIG. 1.
FIGS. 3-7 are diagrams depicting respective emitter configurations that can be employed by an addressable VCSEL illuminator in accordance with various implementations described herein.
FIGS. 8-9 are diagrams depicting example illumination beam widths that can be provided by an addressable VCSEL illuminator in accordance with various implementations described herein.
FIG. 10 is a block diagram of a system that facilitates illumination via an addressable VCSEL illuminator and an optics system in accordance with various implementations described herein.
FIGS. 11-12 are block diagrams of respective systems that facilitate illumination via an addressable VCSEL illuminator and an optics system with separately lensed optical channels in accordance with various implementations described herein.
FIG. 13 is a flow diagram of a method that facilitates illumination via an addressable VCSEL illuminator in accordance with various implementations described herein.
FIG. 14 is a diagram depicting an alternative front view of the emission surface of the VCSEL die of FIG. 1.

### DETAILED DESCRIPTION

Various specific details of the disclosed embodiments are provided in the description below. One skilled in the art will recognize, however, that the techniques described herein can in some cases be practiced without one or more of the specific details, or with other methods, components, materials, etc. In other instances, well-known structures, materials, or operations are not shown or described in detail to avoid obscuring subject matter. Additionally, it is noted that the drawings are not drawn to scale, either within the same drawing or between different drawings.

As noted above, conventional illumination devices generally rely on physical movement of an optical element, such as a lens, relative to an optical source in order to vary an output divergence and/or power of the device. However, reliance upon mechanical part movement and/or adjustment in this manner can result in a number of drawbacks, such as increased parts count, increased device size, and/or inconsistent illumination quality over the output divergence and/or output power ranges of the device, which can adversely affect device performance. Additionally, conventional illuminator devices generally have the disadvantage of limited accessible functionality during field use, as an operator tends to select a "best compromise" divergence and output power and leave the illuminator device in that setting due to the complexity of changing function sets during use.

As used herein, the term "function sets" refers to combinations of illuminators and/or pointers that are matched to different environments. As an example of a function set, a wide divergence and low-power illuminator can be paired with a pointer having lower output power, e.g., to reduce obscuration of details on a nearby target. As another example of a function set, a narrow divergence and high-power illuminator can be paired with a pointer having higher output power, e.g., for use with distant targets. Other examples of function sets are also possible.

To the furtherance of the foregoing and/or related ends, implementations described herein facilitate the use of a multi-element vertical-cavity surface-emitting laser (VCSEL) as an optical source enabling adjustment of an output divergence of an illumination device independent of physical movement of any part of the optical path (e.g., lenses or other optical elements). In implementations, the VCSEL array can include two or more elements that can be independently electrically addressed, such that individual elements of the array can be selectively driven to vary output divergence and/or power.

While various examples are provided herein with reference to an infrared (IR) illumination device, it is noted that these examples are provided merely for purposes of description and that similar concepts to those described herein could be utilized to facilitate illumination using any suitable light wavelength(s), e.g., visible light, near IR, etc., without departing from the scope of this description or the claimed subject matter.

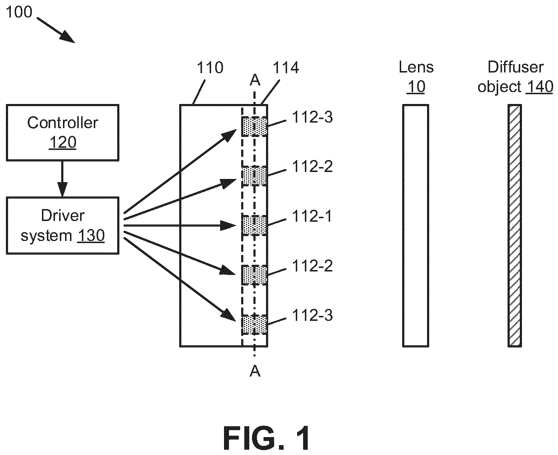

With reference now to the drawings, FIG. 1 illustrates a block diagram of a system 100 that facilitates illumination via an addressable VCSEL illuminator in accordance with various implementations described herein. System 100 as shown in FIG. 1 includes a VCSEL die 110 that is positioned perpendicular to an optical axis of a lens 10, forming an optical path running from the VCSEL die 110, through the lens 10, and towards a far-field target, object, surface, etc. A cross-sectional view of the VCSEL die 110 is provided in FIG. 1, which shows that the VCSEL die 110 includes one or more VCSEL emitter elements that are positioned within respective spatial zones 112 of an emission surface 114 of the VCSEL die 110, here three zones 112-1 through 112-3.

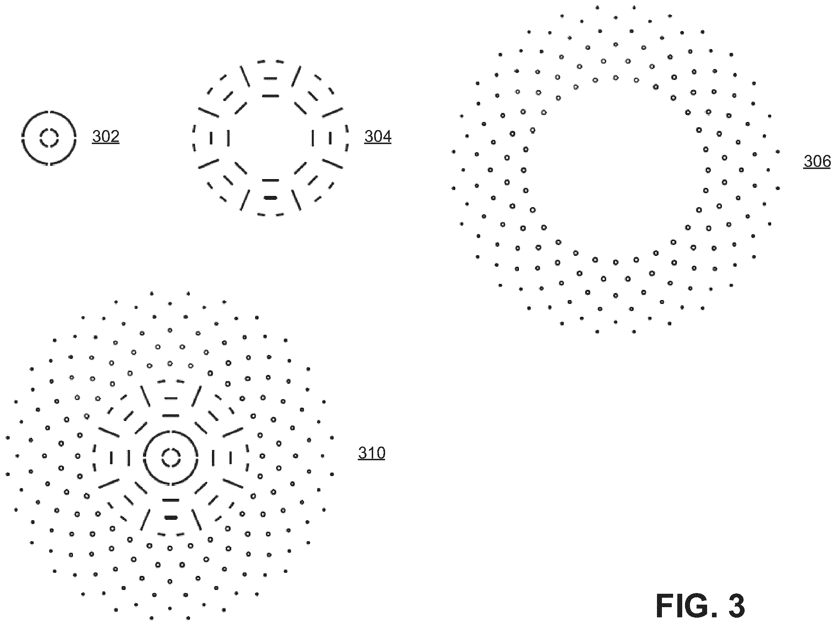

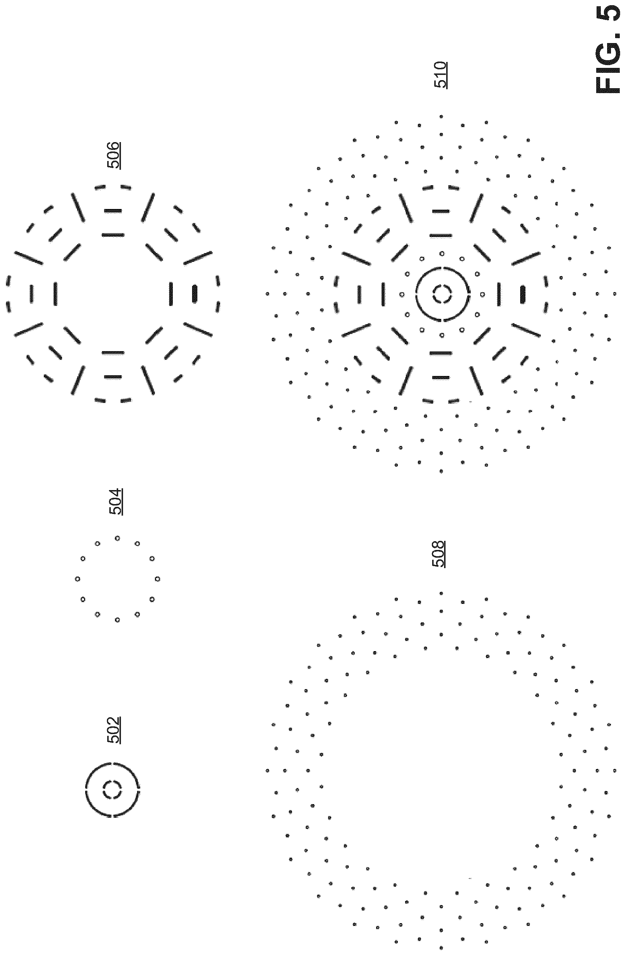

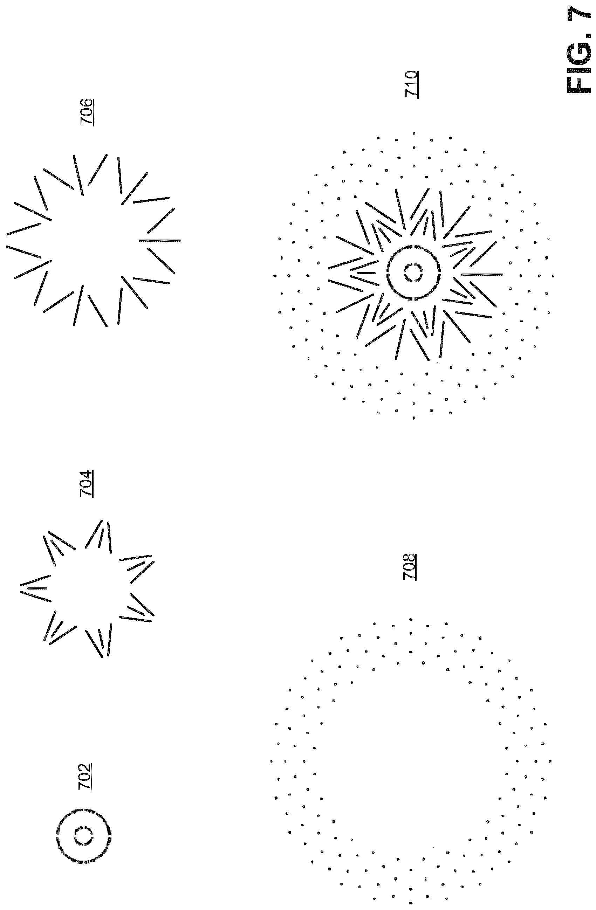

It is noted that three zones 112 are shown in FIG. 1 merely for purposes of illustration and that other numbers and/or configurations of zones are also possible. For instance, emitter layouts for a four-zone arrangement are described in further detail below with respect to FIGS. 5 and 7. In general, the VCSEL die 110 can include any number of zones 112, which in turn can include any number of emitter elements. As will be shown and described below with respect to FIGS. 3-7, each emitter element, in turn, can be composed of one or more lasing segments etched into and/or otherwise positioned on the emission surface 114 of the VCSEL die 110.

While FIG. 1 illustrates a single VCSEL die 110, it is noted that configurations of multiple VCSEL dies could also be used. By way of a non-limiting example, four VCSEL dies could be used, each corresponding to a quadrant of an overall illumination system. Other configurations could also be used that could include any number of VCSEL dies (e.g., four VCSEL dies, five VCSEL dies, six VCSEL dies, eight VCSEL dies, etc.) which could be arranged with respect to each other in any suitable manner, e.g., a rectilinear or radial array of VCSEL dies or VCSEL elements, and/or according to any other suitable spatial arrangement. In implementations, each of the zones 112 shown in FIG. 1 can occupy mutually exclusive (non-overlapping) areas of the emission surface 114 of the VCSEL die 110. It is however noted that the disclosed subject matter is expressly not limited to exclusive or non-overlapping zones and that, in some embodiments, selectable zones can occupy overlapping areas.

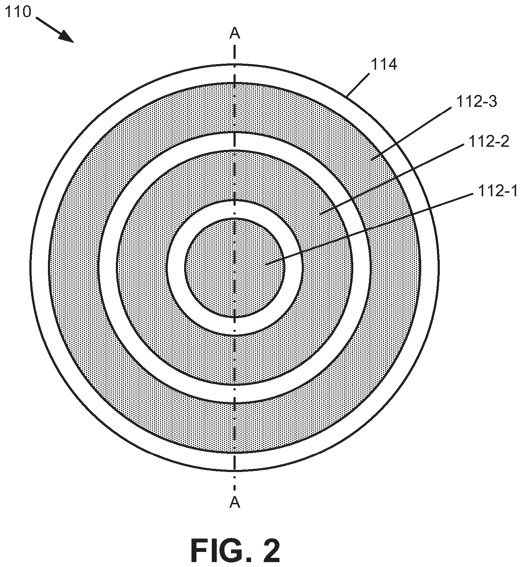

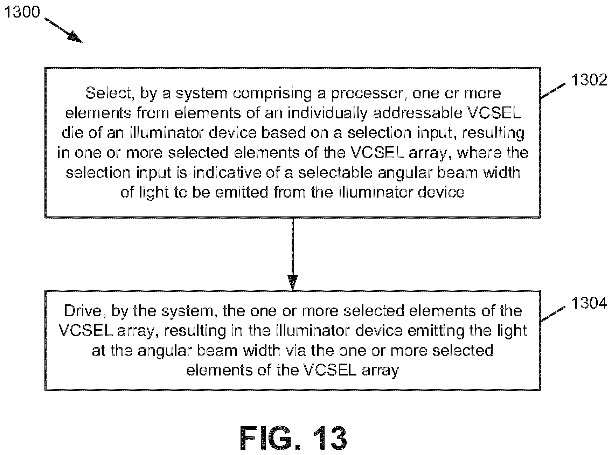

In another non-limiting example, the zones 112 can occupy respective concentric circular regions of the emission surface 114 of the VCSEL die 110, e.g., as shown by FIG. 2. In the example shown by FIG. 2, the respective zones 112 occupy respective non-overlapping regions of the emission surface 114 of the VCSEL die 110, and the zones 112 are structured such that each zone 112 is located at a different distance from a reference point, e.g., a center, etc., of the VCSEL die 110, e.g., as shown by the positions of the zones 112 relative to line A-A in FIG. 1 and FIG. 2. While FIG. 2 illustrates an example in which the zones 112 occupy concentric circular regions of the emission surface 114, it is noted that other region shapes could also be used, such as ellipses, polygons, etc., and that each of the zones 112 could be associated with the same shape and/or different shapes. Additionally, while the VCSEL die 110 is illustrated as rounded in FIG. 2, it is noted that the VCSEL die 110 could alternatively be square, rectangular, and/or of any other suitable shape without altering the spatial properties of the zones 112. An alternative example of a VCSEL die configuration that includes non-circular regions and a non-rounded emission surface 114 is described in further detail below with respect to FIG. 13.

It is further noted with respect to FIG. 2 that, while FIG. 2 shows spatial regions into which VCSEL emitters could be placed within respective zones 112, the actual placement of emitters within each of these zones 112 can vary based on implementation. Various examples of emitter patterns that can be employed are described in further detail below with respect to FIGS. 3-7.

Returning now to FIG. 1, system 100 additionally includes a diffuser object 140, e.g., a diffractive optical element (DOE) or other diffuser, that can be situated opposite the VCSEL die 110 with respect to the lens 10, e.g., resulting in the lens being positioned between the VCSEL die 110 and the diffuser object 140 as shown in FIG. 1. As further shown in FIG. 1, the VCSEL die 110, lens 10, and diffuser object 140 can be aligned such that an optical path of light emitted from the VCSEL die 110 passes through the lens and the diffuser object. In this regard, changes in an intensity of emissions from a portion of VCSEL die 110 can correspond to a change in a far-field intensity, e.g., an intensity incident on an object in the far-field. Changes in far-field intensity can result in a changed far-field intensity profile corresponding to the portion of the far-field area illuminated by energy emitted from a portion of the VCSEL die 110. For example, a far-field intensity profile can change between a Gaussian, Super Gaussian, Flat-Top, Stepped Flat-Top, and/or other far-field intensity profile in conjunction with changes to a far-field intensity, which can in turn correlate to a change in an intensity of an emission from a portion of the VCSEL die 110.

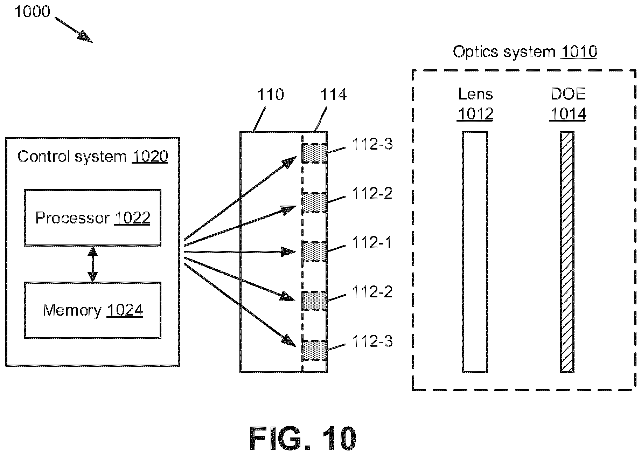

Moreover, as will be described in further detail below with respect to FIG. 10, the diffuser object 140 can be used in combination with a defocused lens 10, i.e., where a distance between the lens 10 and the emission surface 114 of the VCSEL die 110 can differ from a focal length of the lens 10 by at least a threshold amount, to facilitate smoothing of an illumination beam produced by the system 100. In some embodiments, the smoothing can be achieved by use of the diffuser object 140 with the VCSEL die 110 at the focal length of the lens 10. In other embodiments, acceptable smoothing can be achieved by de-focusing, e.g., where the VCSEL die 110 is not at the focal length, without use of a diffuser. In this regard, characteristics of a far-field illumination pattern, such as a smoothness of the illumination field (e.g., in terms of a level of speckle and/or brightness in downrange illumination), etc., can correspond to a level of defocus and/or a level of diffusion, where the level of defocus relates to the positioning of the VCSEL die relative to a lens, and where the level of diffusion relates to a diffuser object placed, or not placed, in the optical path. It is noted that, as will be appreciated by one of skill in the related arts, all discussions of focal length herein relate to a focal length of a single lens or a combination of lenses.

The herein disclosed control over far-field illumination characteristics, e.g., intensity, intensity profile, speckle, smoothness, etc., can, in some embodiments, be employed to define one or more well defined illuminated-dark edges of a projected beam that can, for example, enable illumination of a target at a long distance with correspondingly less (or no) illumination of an object closer than the target. This can, for example, be useful to operators of night vision equipment by reducing the likelihood of the night vision equipment "gaining down," where a closer object is illuminated while also illuminating a more distant target and thereby reducing visibility of the target (as a result of the lower gain from the night vision equipment). In this example, controlling which portions of the VCSEL die 110 are active, what intensity of emissions is generated by each of the portions, and how defocused and/or diffused the emissions are, the disclosed subject matter can more selectively illuminate a target than an object closer to a user than the target, whereby night vision equipment of the user can run at a gain appropriate to the target illumination than a gain appropriate for the object closer than the target.

System 100 as shown in FIG. 1 also includes a controller 120 that can select emitter elements, of the emitter elements of the VCSEL die 110 and positioned within respective selected spatial zones of the zones 112, based on a target angular beam width of light to be emitted from the system 100, e.g., from the emission surface 114 of the VCSEL die 110 through the lens 10 and the diffuser object 140. To state this another way, the emitter elements of the VCSEL die 110 can be considered as an array, and this array can be divided into elements corresponding to the respective spatial zones 112. These array elements can be individually addressable by the controller 120, which can enable the controller 120 to selectively operate respective elements of the array independently of each other.

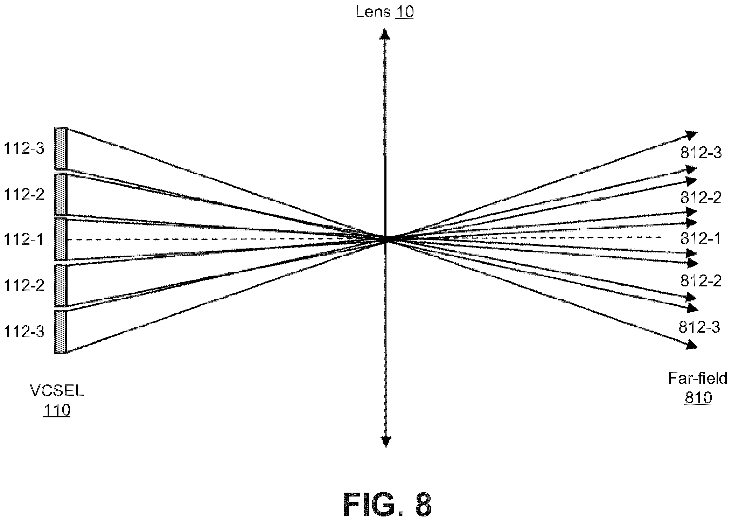

In an implementation, an amount and/or arrangement of emitter elements selected by the controller 120 can be approximately proportional to a desired illumination beam width to be provided by system 100, e.g., as provided via a selection input to the controller 120 and/or by other means. For instance, in the example shown by FIGS. 1-2, the controller 120 could select zone 112-1 to facilitate a pointer or a narrow-width illumination beam. In the event that a wider illumination beam is desired, the controller could additionally select zone 112-2, or zones 112-2 and 112-3, depending on the desired beam width. Additionally, a wider illumination beam can also be achieved by selecting zone 112-2 (and/or 112-3) and deselecting zone 112-1. Similarly, a wider illumination beam can additionally be achieved by selecting zone 112-3 and deselecting zone 112-1 and/or 112-2. Numerous other combinations of zones can be selected to achieve desired illumination beam characteristics. Examples of relationships between selected VCSEL array elements and resulting far-field beam widths are described in further detail below with respect to FIGS. 8-9.

As used herein, the term "beam width" or "angular beam width" refers to an angle formed by respective reference points associated with an illumination beam produced by the system 100. Beam width can be expressed in terms of a full angle, e.g., an angle formed from a first point on the edge of an illumination beam to a second point on the edge of the illumination beam that is opposite the first point, or a half angle, e.g., an angle formed from a point on the edge of an illumination beam to the center of the illumination beam. Additionally, the "edge" of an illumination beam can be defined according to any suitable criteria. For example, the edge of an illumination beam can be defined based on the 1/e² diameter of the beam, which refers to a set of opposing points at which an illumination intensity of the beam is 1/e², or approximately 13.5%, of the maximum illumination intensity of the beam (e.g., at the center of the beam). Other definitions could also be used.

While not shown in FIG. 1 for simplicity of illustration, the controller 120 can be implemented as a computing device, e.g., an embedded computer, etc., that can include a memory (e.g., an instruction memory, etc.) on which computer-executable instructions are stored and a processor that can execute the stored instructions, e.g., to facilitate a selection of emitter elements based on a selection input and/or to facilitate other operations. The controller 120 can also include and/or interface with other devices, such as manual input devices (e.g., a knob or dial, a keypad, etc.) that facilitate entry of a selection input corresponding to a desired function set of the system 100. Also, or alternatively, illumination sensors, automatic feedback systems, and/or other devices can automatically produce a selection input based on various factors. For instance, the selection input can be determined based on a sensed illumination level of a given downrange target in the optical path of light emitted from the VCSEL die 110 as sensed prior to selection of emitter elements, or adaptation of already selected emitter elements, and/or other criteria. It is noted that, in some implementations, devices with which the controller 120 can interact can include devices external to the system 100 that can be communicatively coupled to the system 100 via any suitable wired or wireless communication technologies.

As additionally shown in FIG. 1, system 100 includes a driver system 130 that can selectively apply a drive signal to the emitter elements selected by the controller 120 as described above, e.g., in response to those emitter elements being selected by the controller 120. While the controller 120 and the driver system 130 are illustrated as separate blocks in FIG. 1 to highlight the functionality of the respective blocks, it is noted that the controller 120 and driver system 130 could, in some implementations, be implemented via common hardware. The drive signal provided by the driver system 130 can be any signal, such as a fixed width signal, a pulse width modulated (PWM) signal or other alternating signal, or the like, that is suitable for energizing respective emitter elements of the VCSEL die 110 such that the emitter elements emit light in response to the drive signal.

In an implementation, respective emitter elements associated with the VCSEL die 110 can be electrically coupled to the driver system 130 via wires, leads, traces, and/or other appropriate means. In response to the controller 120 selecting one or more zones 112, the driver system 130 can provide a drive signal by applying current to respective emitter elements in the selected zone(s) 112 via the electrical coupling(s) between the driver system 130 and the selected zone(s) 112. These electrical couplings can be placed on the emission surface 114 of the VCSEL die 110, e.g., in a manner such that the electrical couplings do not overlap with each other or with any VCSEL emitters. Alternatively, the electrical couplings could run from off the surface of the VCSEL die 110, through an interior of the VCSEL die 110, e.g., via a multilayer die process, and/or in any other suitable manner.

In some implementations, the driver system 130 can provide a drive signal to less than all of the emitter elements in a given zone 112. This could be done, e.g., based on a total amount of power available to system 100, in response to an additional control input provided to the controller 120, and/or based on other criteria.

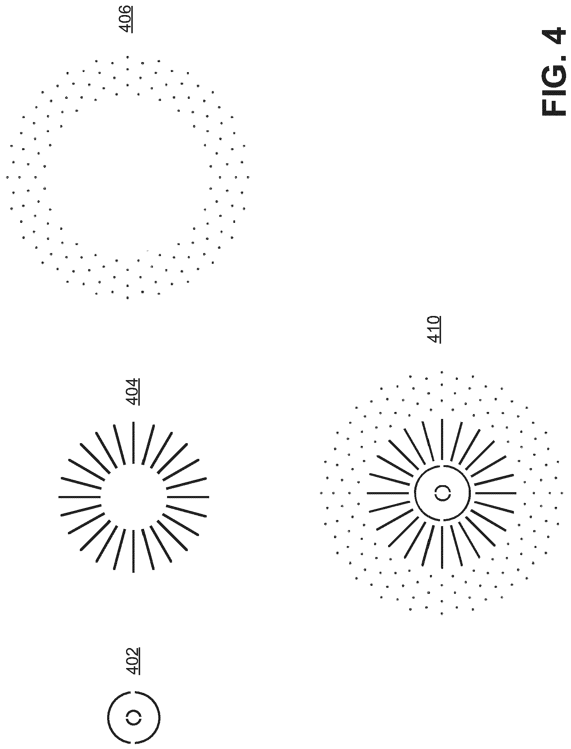

Turning now to FIGS. 3-7, respective emitter configurations that can be employed by an addressable VCSEL illuminator in accordance with various implementations described herein are illustrated. A general description of emitter configurations will now be provided with respect to FIG. 3, and then the emitter configurations shown in FIG. 3 will be contrasted to the alternative configurations shown in FIGS. 4-7.

With reference to FIG. 3, example emitter configurations that can be utilized for a VCSEL array, here an array 310 of three zones 302, 304, 306, are illustrated. The patterns shown for each of the zones 302, 304, 306 can be composed of laser cavities, e.g., segments, etched and/or otherwise placed into the emission surface of a VCSEL die, e.g., the emission surface 114 of the VCSEL die 110 described above with respect to FIGS. 1-2, where each of the laser cavities operate as a lasing segment within the VCSEL array and groups of one or more lasing segments form emitter elements as described above. In general, the laser cavities can be patterned to form the emitter configurations shown in zones 302, 304, 306.

As described above, respective emitter segments, elements, and/or zones of a VCSEL array can operate independently from each other, which can enable respective zones, elements, or even individual segments within a given zone or element, to be independently driven to shape an illumination beam provided by the array. As further shown by FIG. 3, the respective zones 302, 304, 306 can be placed together, e.g., by patterning the zones 112 as shown in FIG. 2 according to the patterns of zones 302, 304, 306 as shown in FIG. 3, to produce a full three-zone array 310.

As shown in FIG. 3, cavity patterns corresponding to a given emitter configuration can include point cavities, such as those along the outer ring of zone 306, as well as stripe cavities, such as those shown in zones 302 and 304. As shown in FIG. 3, the shapes of respective cavities can define extents of the boundaries from which photons are emitted from the associated VCSEL. Stated differently, in response to a given segment being driven and/or otherwise enabled, light produced by the segment will be bounded by the boundaries of the segment. Moreover, segment shape can correspond to photoemission characteristics, such that for a given drive condition, differently shaped segments can emit different amounts of photons, different concentrations of photons per unit area, different uniformities of photon emission, etc. In this regard, VCSEL die patterning of segments, at the design stage, can employ segment shape designs that can provide particular advantages once deployed in the field. As a result, the respective zones 302, 304, 306 of the array 310 can produce an illumination pattern in the far field that is correlated to the pattern of the respective segments that make up the array 310. As will be described below, lens defocusing, optical diffusion, selection of a segment based on segment shape, and/or other techniques can be utilized to disperse this pattern to create a more uniform illumination beam throughout an area projected by the array 310.

It is noted that the array element patterns shown in FIG. 3 are merely one example of patterns that can be utilized and that other patterns can also be used. For example, FIG. 4 shows an alternative pattern that can be utilized for a three-zone array 410 from three zones 402, 404, 406. It is further noted that while FIGS. 3-4 illustrate patterns for three-zone arrays, other numbers of array elements could also be used. For instance, FIG. 5 illustrates an example four-zone array 510 that can be constructed from respective zones 502, 504, 506, 508.

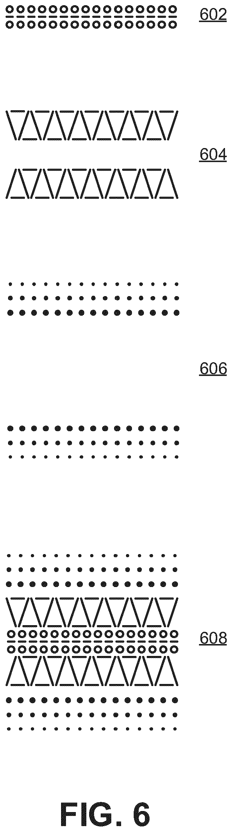

In addition to the circular patterns illustrated by FIGS. 3-5, other cavity patterns could also be employed, such as those associated with rectilinear or other arrays. As an example, FIG. 6 shows an example rectilinear three-zone array 610 that can be constructed from respective zones 602, 604, 606. The pattern shown by FIG. 6 could be utilized, for example, in a system that includes a cylindrical lens and/or other lens types.

As another alternative configuration as shown by FIG. 7, another example circular four-zone array 710 can be constructed from zones 702, 704, 706, 708. Unlike the concentric circular zones illustrated by FIGS. 3-5, zones 704 and 706 are not concentric circles and are associated with overlapping distance ranges from a center of the array 710.

With reference next to FIG. 8, an example illumination beam that can be provided by an addressable VCSEL illuminator in accordance with various implementations described herein is illustrated. Repetitive description of like parts described above with regard to other implementations is omitted for brevity. More particularly, FIG. 8 illustrates a relationship between the output divergence of light emitted from respective zones 112 of a VCSEL 110 and the corresponding components 812 of an illumination beam produced in the far field 810. As used herein, the term "far field" refers to a location opposite the lens from the VCSEL 110, e.g., corresponding to a target or object downrange that is desirably illuminated by the VCSEL 110.

As shown by FIG. 8, the VCSEL 110 can include an array of multiple emitter elements, e.g., within the zones 112, that can be independently electrically addressed. It is noted that in embodiments individual segments can be electrically addressed, albeit with generally greater complexity in electrical connectivity. As such, it can be favorable to address groups of segments, e.g., elements. By enabling independent operation of the respective array elements, the operable optical source size of the VCSEL 110 can be varied based on a desired output angular divergence. For instance, turning on only zone 112-1 results in a 'minimum' divergence (e.g., given by beam component 812-1), turning on zones 112-1 and 112-2 results in a 'mid-range' divergence (e.g., given by beam components 812-1 and 812-2), and turning on all three zones 112-1, 112-2, 112-3 results in the 'greatest' divergence (e.g., given by beam components 812-1, 812-2, 812-3).

As described above, each of the zones 112, their constituent emitter elements, and/or the shape of constituent segments can be patterned, e.g., as described above with respect to FIGS. 3-7 and/or in other suitable patterns, to produce an optical source that provides smoothness in the far field 810. Suitable patterns can blend the effects resulting from a shape of an emitter segment with the effects of a first geometry of segments in an element and/or a second geometry of selectable elements in a zone. Generally, the emitter segment shapes and the first geometry of the segments in the element are each fixed at VCSEL die design, while the second geometry can remain selectable at use, e.g., such that different elements of a zone can be selected and/or driven independently. As noted above with respect to FIG. 1, to further disperse the source pattern and project a beam with improved smoothness, the light emitted by the VCSEL 110 can pass through a lens 10 that is defocused relative to the VCSEL 110, e.g., such that a distance between the lens 10 and the VCSEL 110 differs from a focal length of the lens by at least a threshold amount. Further dispersion and/or smoothing can be achieved by adding a controlled scattering surface, such as a holographic diffuser (e.g., a diffuser object 140) and/or other optical elements, between the lens 10 and the far field 810.

In some implementations, a far field illumination angle as shown by FIG. 8 can be adjusted, e.g., by a controller 120 as described above with respect to FIG. 1 and/or by other mechanisms, without mechanically changing the position of the VCSEL 110 or the lens 10. For instance, a knob, wheel, illumination sensor, or other control device could be associated with the VCSEL 110, which can enable selection of a desired amount of far-field angular divergence. Based on this selection, the controller 120 can select a number of VCSEL array elements to enable, e.g., in order to produce the desired amount of illumination as shown by FIG. 8.

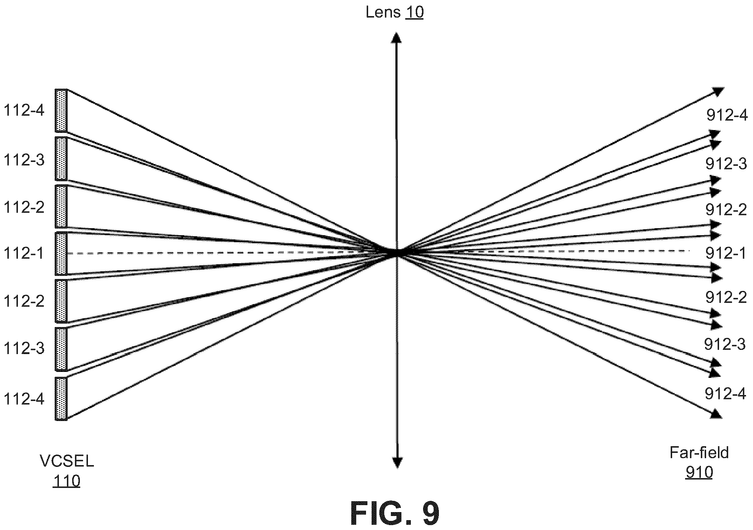

While FIG. 8 illustrates an example of a three-zone array, other array types could be used. For instance, FIG. 9 illustrates an example VCSEL 110 having four zones 112, which can be selectively enabled and/or disabled in a similar manner to that described above with respect to FIG. 8 to produce an appropriate level of illumination in the far field 910, e.g., composed of beam components 912 corresponding to the enabled zones 112. Other examples are also possible.

In one implementation of the examples shown by FIG. 8 and/or FIG. 9, and with further reference to FIG. 1, the controller 120 and/or driver system 130 can vary the electrical drive provided to the VCSEL 110. For example, a VCSEL 110 can be driven with a constant input current that results in an output power at a given divergence. The drive current of the VCSEL could also be produced via pulse width modulation (PWM) and/or other techniques which can result in lasing in an efficient drive current regime at each example pulse (of the PWM) but causing average illumination levels that can be reduced in comparison to driving the lasing at the same current in a constant current mode. As an example, a VCSEL segment can lase more efficiently at a first current than at a second current. In this example, the level of illumination desired can be less that that produced by the VCSEL segment if driven at the first current in a constant current mode. Accordingly, in this example, the VCSEL can be driven at the second current to achieve the desired illumination at the cost of operating less efficiently. This can be less desirable, especially where the VCSEL may be driven by a battery power source and high efficiency can be desirable. As such, rather than driving at the second current, the VCSEL can be driven, in this example, in a PWM scheme at the first current allowing for efficient lasing while also allowing for the average illumination to be reduced based on the duty cycle of the PWM driving scheme. In some embodiments, lowering illumination from a segment can correspond to an apparent smoothing of far field illumination, e.g., less speckling in the far field, etc.

Thus, in one example in which a drive signal produced by the driver system 130 of FIG. 1 is a PWM signal, the driver system 130 can set a duty cycle, and/or other properties of the signal, based on the target beam width to be provided via the VCSEL. This can reduce the variance in the total amount of power usage by the system resulting from changes to the target beam width, e.g., as achieved by enabling or disabling varying amounts of emitters associated with the VCSEL 110. In addition to smoothing the total amount of power consumption, varying the duty cycle of a drive signal in this manner can also be used to stabilize the VCSEL 110 over temperature, e.g., to obtain average output power that is similar to a continuous wave input with less temperature variance than that associated with a continuous wave input.

Also or alternatively, the duty cycle of a drive signal can be varied in order to vary the total amount of power provided to the VCSEL 110, e.g., to adjust the brightness of illumination produced by the VCSEL 110, while keeping the VCSEL 110 within its rated output power. By way of non-limiting example, a given VCSEL can operate most efficiently at a power level that is a percentage of its rated output power, e.g., between 60 to 100 percent of the rated output power. Accordingly, if a power level that is less than this efficiency level is desired, a drive signal can be provided to the VCSEL at the efficiency level and modified via PWM and/or other techniques such that an average power level provided to the VCSEL is the desired amount.

In addition to modifying a drive signal provided to the entire VCSEL using PWM or the like, power levels provided to individual emitter elements, or individual segments within emitter elements, could also be modified, e.g., to cause some emitter elements and/or segments to be brighter or dimmer than others.

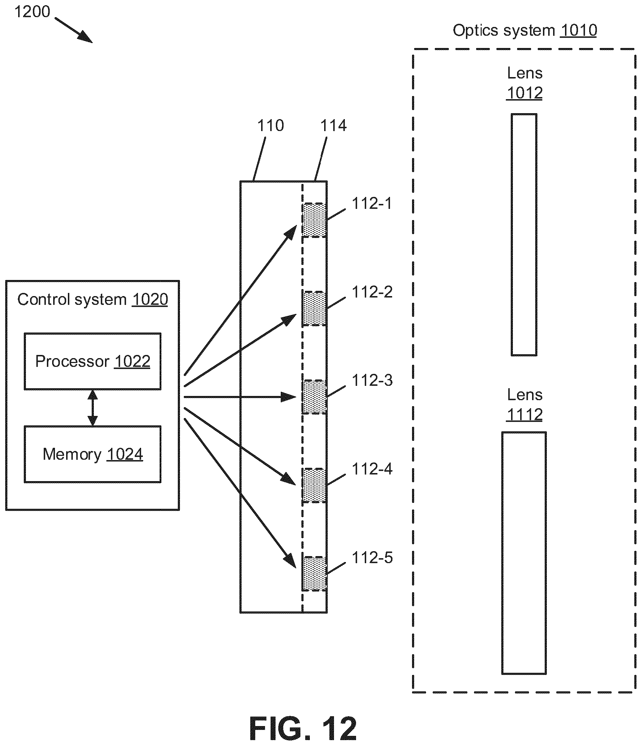

In the examples shown by FIGS. 8-9, the lens 10 is fixed at a given distance from the VCSEL 110, e.g., a distance that differs from a focal length of the lens 10, to facilitate visual dispersion of the illumination pattern. In some implementations, the lens 10 could be mechanically adjustable within a small range, e.g., a range between the VCSEL 110 and the far field 810/910, to facilitate fine tuning of an illumination angle and/or pattern produced by the VCSEL 110. In other implementations, respective elements of the VCSEL 110 can be selectively activated and/or deactivated to alter a far-field illumination pattern produced by the VCSEL 110, e.g., via a "digital shifting" process, as will be described in further detail below with respect to FIG. 12.

Turning now to FIG. 10, a block diagram of a system 1000 that facilitates illumination via an addressable VCSEL illuminator and an optics system 1010 is illustrated. Repetitive description of like parts described above with regard to other implementations is omitted for brevity. System 1000 as shown in FIG. 10 includes a VCSEL die 110, which can include VCSEL emitters arranged on respective regions 112 of an emission surface 114 of the VCSEL die 110, e.g., in a similar manner to that described above with respect to FIGS. 1-2. As described above with respect to FIGS. 3-7, the VCSEL emitters can include respective groups of one or more lasing segments (e.g., laser cavities) that are etched into the emission surface 114 of the VCSEL die 110.

The system 1000 shown by FIG. 10 further includes an optics system 1010 that is situated within an optical path of the emission surface 114 of the VCSEL die 110. In the example shown by FIG. 10, the optics system 1010 includes a lens 1012, which can be defocused relative to the VCSEL die 110 to facilitate visual dispersion of a pattern produced by the VCSEL die 110, e.g., as described above with respect to FIGS. 8-9. The lens 1012 can be composed of any material(s) through which light may pass, such as glass, polycarbonate and/or other plastics, or the like. Additionally, the lens 1012 can be shaped in any suitable manner to enable a desired spreading pattern for light produced by the VCSEL emitters, e.g., as shown in FIGS. 8-9 above.

In addition to the lens 1012, the optics system 1010 further includes a DOE 1014 that is situated opposite the VCSEL die 110 with respect to the lens 1012, e.g., such that an optical path of light from the VCSEL die 110 runs through the lens 1012 and DOE 1014 of the optics system 1010. The DOE 1014 can include a holographic diffuser and/or another suitable scattering surface that can further visually disperse the illumination pattern produced by the emitters of the VCSEL die 110, resulting in a level of smoothness of a resulting illumination beam.

In an implementation, the DOE 1014 can be placed at a sufficient distance from the lens 1012 such that the DOE 1014 does not impact the power of the lens 1012. For example, in an implementation in which the VCSEL die 110 and the optics system 1010 are housed by a device housing, the DOE 1014 can be placed on an output window or opening at the perimeter of the device housing. Additionally, an amount of light diffraction performed by the DOE 1014 can be limited such that it does not impact the ability of system 1000 to vary the divergence of a produced illumination beam. While the DOE 1014 is shown in FIG. 10 as having the same diameter as the lens 1012, it is noted that the DOE 1014 can have a different diameter from the lens 1012.

While the optics system 1010 shown in FIG. 10 only includes a single lens 1012 and DOE 1014, additional optical elements, such as additional diffusers, lenses, or the like, can also be part of the optics system 1010.

The system 1000 shown by FIG. 10 additionally includes a control system 1020 that can energize selected ones of the emitters on the emission surface 114 of the VCSEL die 110 based on a selection input (e.g., an input similar to that provided to the controller 120 of FIG. 1 as described above), which in turn can cause light emitted from the selected VCSEL emitters to leave the optics system 1010, e.g., via the lens 1012 and DOE 1014, at a target angular beam width associated with the selection input. For example, the control system 1020 can selectively turn on and/or off zones 112 associated with the VCSEL die 110 to achieve a desired illumination angle in a similar manner to that described above with respect to FIGS. 8-9.

As shown in FIG. 10, the control system 1020 of system 1000 can include a processor 1022 and a memory 1024, which can be utilized to implement at least a portion of the functionality of the control system 1020. For instance, the memory 1024 can include one or more data storage devices onto which computer-executable instructions can be stored, and the processor 1022 can be operable to execute the instructions stored on the memory 1024 to facilitate performance of operations. In some implementations, the control system 1020 can be implemented as an embedded computer within an illuminator device that also includes one or more of the VCSEL die 110 and the optics system 1010. In other implementations, the control system 1020 could be implemented via a general-purpose computer and/or another suitable device that is separate from an illuminator device that includes the VCSEL die 110 and/or the optics system 1010. Other implementations could also be used.

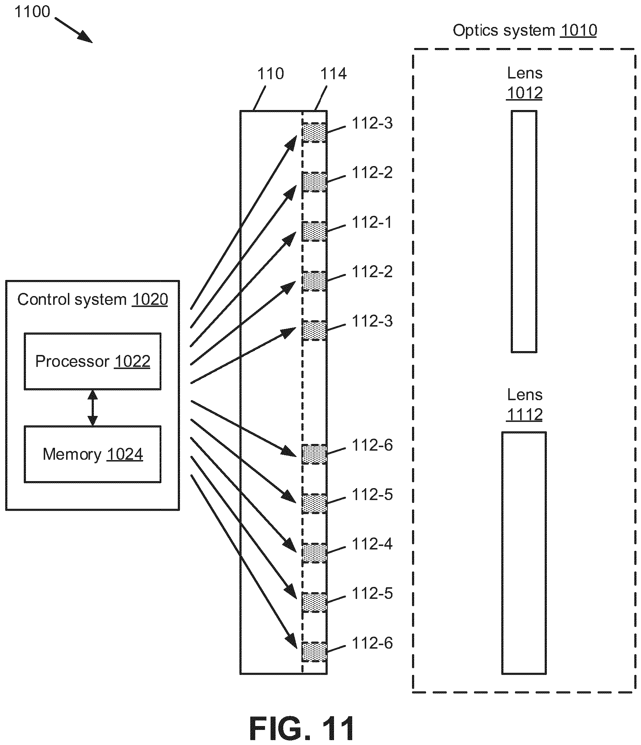

With reference now to FIG. 11, a block diagram of a further system 1100 that facilitates illumination via an addressable VCSEL illuminator and an optics system 1010 is illustrated, in which separately lensed optical channels can be used to facilitate a staggered divergence range. System 1100 as shown in FIG. 11 includes a VCSEL die 110 having two VCSEL arrays. The first array includes first groups of the VCSEL emitters of the VCSEL die 110, corresponding to spatial regions 112-1, 112-2, 112-3, that are positioned within a first area of the emission surface 114 of the VCSEL die 110. The second array includes second groups of the VCSEL emitters of the VCSEL die 110, corresponding to spatial regions 112-4, 112-5, 112-6, that are positioned within a second area of the emission surface 114 of the VCSEL die 110. In various embodiments, each of the regions 112 shown in FIG. 11 can include VCSEL emitters composed of respective lasing segments that form an illumination pattern, e.g., such as those described above with respect to FIGS. 3-7.

As further shown in FIG. 11, system 1100 includes an optics system 1010 having two lenses, namely a first lens 1012 and a second lens 1112 that are positioned such that respective optical axes of the lenses 1012, 1112 are orthogonal to the first VCSEL array (zones 112-1, 112-2, 112-3) and the second VCSEL array (zones 112-4, 112-5, 112-6), respectively. The lenses 1012, 1112 of the optics system can be positioned such that they are aligned with the regions 112 of the VCSEL die 110. For instance, the first lens 1012 can be positioned such that a given area of the lens 1012 (e.g., a center point of the lens 1012) is aligned with a corresponding point of the first VCSEL array, and the second lens 1112 can be positioned such that a given area of the lens 1112 (e.g., a center point of the lens 1112) is aligned with a corresponding point of the second VCSEL array. While not shown in FIG. 11 for simplicity, it is noted that the optics system 1010 shown in FIG. 11 could also include DOEs and/or other diffuser objects for one or more of the optical channels of the optics system 1010, e.g., as described above with respect to FIGS. 1 and 10.

As shown in FIG. 11, the lenses 1012, 1112 can differ in size, materials, and/or other properties such that the lenses 1012, 1112 have different focal lengths. When paired with VCSEL arrays that are identical and/or are otherwise similar in size, the lenses 1012, 1112, along with their paired VCSEL arrays, can facilitate the use of additional divergence ranges without increasing the size and/or power consumption of either of the arrays. By way of example, a three-zone array can be positioned behind a 15mm focal length lens, and another three-zone array of similar size can be positioned behind a 5mm focal length lens to create a six-step divergence with greater total divergence range. In such an example, the control system 1020 could drive the appropriate segments of the array behind the 15mm lens to provide an initial three steps of divergence (e.g., as described above with respect to FIG. 8), and then switch to driving the appropriate segments of the array behind the 5mm lens to provide three additional (wider) steps of divergence. In another example, two similar VCSEL arrays could be positioned behind 15mm and 12mm focal length lenses, respectively, to slightly increase the total divergence range while decreasing the size of the steps between minimum and maximum divergence.

In the example shown by FIG. 11, two VCSEL arrays are positioned behind respective lenses 1012, 1112 of the optics system 1010, and the VCSEL arrays and lenses 1012, 1112 can be positioned next to each other, e.g., in a device housing or the like, such that light emitted from the VCSEL arrays is projected into the far field, e.g., towards a target. While FIG. 11 illustrates an example in which two VCSEL arrays and lenses are used, it is noted that system 1100 could include any suitable number of VCSEL arrays and/or lenses, e.g., to facilitate additional or finer divergence steps. By way of example, system 1100 could alternatively include one lens, or three or more lenses, in some implementations as appropriate to facilitate a desired range of function sets. Additionally, while system 1100 includes a single VCSEL die 110 and a single control system 1020, it is noted that one or more of the zones 112 shown in FIG. 11 could instead be implemented via separate VCSEL dies, which could be driven by the same control system and/or different control systems. For instance, as described above with respect to FIG. 1, the zones 112 shown in FIG. 11 could be implemented via any suitable number of two or more arrays, which could be arranged in any suitable manner with respect to each other and/or the lens(es) of the optics system 1010.

In contrast to FIG. 11, FIG. 12 illustrates another system 1200 in which the optics system 1010 and control system 1020 of FIG. 11 is paired with a single VCSEL array, e.g., an array of five zones 112-1 through 112-5 formed in an emission surface 114 of a VCSEL die 110. Similar to system 1100 as described above with respect to FIG. 11, the far-field divergence of illumination produced by system 1200 can be adjusted both by varying the number of zones 112 that are driven by the control system 1020 (e.g., producing a level of far-field illumination that is proportional to the number of zones 112, or VCSEL elements within those zones 112, that are activated) as well as by utilizing lenses 1012, 1112 of different focal lengths for finer tuning of the illumination angle and/or pattern.

In the example shown by FIG. 12, the control system 1020 can also facilitate digitally "shifting" the active elements of the VCSEL die 110, e.g., by changing the zones 112 of the VCSEL die 110, and/or individual elements of respective zones 112, that are active in order to affect the location on the VCSEL die 110 from which light is emitted, a pattern of that emitted light, and/or other properties. Stated another way, the control system 1020 can alter the selected elements and/or zones 112 for light emission in order to shift and/or otherwise move an active area of the VCSEL die 110 from a first position of the emission surface 114 of the VCSEL die 110 to a second, different area of the emission surface 114. It is noted that digital shifting can also be employed in this manner for a singlelens system, such as that shown in FIG. 1, and/or other multi-lens configurations other than those shown by FIGS. 11-12.

In an implementation, the control system 1020 can utilize digital shifting in this manner to direct light emitted from the VCSEL die 110 through a selected lens 1012, 1112 of the optics system 1010, e.g., to change the properties of the resulting illumination beam (e.g., speckle pattern, brightness, divergence, etc.) based on the selected lens. Digital shifting of an illumination pattern and/or lens selection can be performed based on any suitable control input(s), such as those described above with respect to FIG. 1.

Turning to FIG. 13, a flow diagram of a method 1300 that facilitates illumination via an addressable VCSEL illuminator is illustrated. At 1302, a system comprising a processor (e.g., a controller 120, or a control system 1020 comprising a processor 1022) can select one or more elements from elements of an individually addressable VCSEL die of an illuminator device (e.g., corresponding to respective zones 112 associated with a VCSEL die 110) based on a selection input, resulting in one or more selected elements of the VCSEL array. The selection input can be indicative of a selectable angular beam width of light to be emitted from the illuminator device.

At 1304, the device can drive (e.g., by a driver system 130, or a control system 1020) the element(s) of the VCSEL array that were selected at 1302, resulting in the selected element(s) of the VCSEL array emitting light through a lens and a diffuser in an optical path of the VCSEL array, where the lens is positioned at a distance from the VCSEL array that differs from a focal length of the lens, such that the light is emitted from the illuminator device at the desired angular beam width.

Upon conclusion of method 1300, additional actions could be performed as desired in order to modify the angular beam width, e.g., based on an updated selection input. For example, the device can facilitate selection of more, or fewer, elements of the VCSEL array in order to increase or decrease the beam width produced by the illuminator device, respectively. As another example, the device could switch from driving elements of the VCSEL array to driving elements of another VCSEL array, e.g., a VCSEL array coupled with a lens having a different focal length than a lens coupled to the first VCSEL array, to facilitate additional modification to the beam width as described above with respect to FIGS. 11-12. Similarly, a device could drive a different portion of a VCSEL to facilitate additional modification to the beam width as described above with respect to FIG. 12.

FIG. 13 as described above illustrates a method in accordance with certain embodiments of this disclosure. While, for purposes of simplicity of explanation, the method has been shown and described as series of acts, it is to be understood and appreciated that this disclosure is not limited by the order of acts, as some acts may occur in different orders and/or concurrently with other acts from that shown and described herein. For example, those skilled in the art will understand and appreciate that methods can alternatively be represented as a series of interrelated states or events, such as in a state diagram. Moreover, not all illustrated acts may be required to implement methods in accordance with certain embodiments of this disclosure.

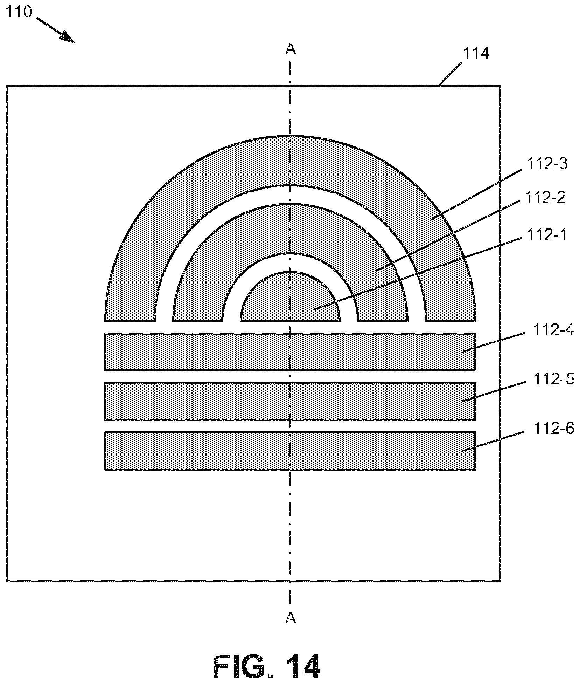

Turning next to FIG. 14, a diagram depicting an alternative front view of the emission surface 114 of the VCSEL die 110 of FIG. 1 is illustrated. In contrast to the rounded emission surface 114 shown in FIG. 2, the VCSEL die 110 shown in FIG. 14 has a polygonal (square, rectangular) emission surface 114 on which spatial zones 112, here six spatial zones 112, are situated. A first group of the spatial zones 112 as illustrated in FIG. 14, including spatial zones 112-1, 112-2, and 112-3, are semicircular and/or semi-toroidal in shape, while a second group of the spatial zones 112, including spatial zones 112-4, 112-5, and 112-6, are rectangular regions. It is noted that the shapes of the respective spatial zones 112 and the emission surface 114 shown in FIG. 14 are merely for illustrative purposes and that other shapes could also be used.

As additionally shown in FIG. 14, the spatial zones 112 are offset from a reference point, e.g., a center, etc., of the emission surface 114 of the VCSEL die 110, e.g., as shown by the offset of line A-A, which runs through the center of the spatial zones 112, relative to the center of the emission surface 114. This can be done, for example, to accommodate other electrical components and/or objects that are desirably also positioned on the emission surface 114 and/or for other reasons, such as to facilitate optimal positioning of the spatial zones 112 within an associated illuminator device. Also or alternatively, the spatial zones 112 can occupy less than all of the area of the emission surface 114, e.g., in order to enable a lens (not shown in FIG. 13) to be moved relative to the emission surface 114. By way of example, a lens can be positionable (e.g., via digital shifting as described above with respect to FIG. 12) in a first orientation that is centered on and/or otherwise placed within an optical path of spatial zones 112-1, 112-2, 112-3, and/or a second orientation that is centered on and/or otherwise placed within an optical path of spatial zones 112-4, 112-5, 112-6.

The above description includes non-limiting examples of the various embodiments. It is, of course, not possible to describe every conceivable combination of components or methodologies for purposes of describing the disclosed subject matter, and one skilled in the art may recognize that further combinations and permutations of the various embodiments are possible. The disclosed subject matter is intended to embrace all such alterations, modifications, and variations that fall within the spirit and scope of the appended claims.

With regard to the various functions performed by the above described components, devices, circuits, systems, etc., the terms (including a reference to a "means") used to describe such components are intended to also include, unless otherwise indicated, any structure(s) which performs the specified function of the described component (e.g., a functional equivalent), even if not structurally equivalent to the disclosed structure. In addition, while a particular feature of the disclosed subject matter may have been disclosed with respect to only one of several implementations, such feature may be combined with one or more other features of the other implementations as may be desired and advantageous for any given or particular application.

The terms "exemplary" and/or "demonstrative" as used herein are intended to mean serving as an example, instance, or illustration. For the avoidance of doubt, the subject matter disclosed herein is not limited by such examples. In addition, any embodiment or design described herein as "exemplary" and/or "demonstrative" is not necessarily to be construed as preferred or advantageous over other embodiments or designs, nor is it meant to preclude equivalent structures and techniques known to one skilled in the art. Furthermore, to the extent that the terms "includes," "has," "contains," and other similar words are used in either the detailed description or the claims, such terms are intended to be inclusive - in a manner similar to the term "comprising" as an open transition word - without precluding any additional or other elements.

The term "or" as used herein is intended to mean an inclusive "or" rather than an exclusive "or." For example, the phrase "A or B" is intended to include instances of A, B, and both A and B. Additionally, the articles "a" and "an" as used in this application and the appended claims should generally be construed to mean "one or more" unless either otherwise specified or clear from the context to be directed to a singular form.

The term "set" as employed herein excludes the empty set, i.e., the set with no elements therein. Thus, a "set" in the subject disclosure includes one or more elements or entities. Likewise, the term "group" as utilized herein refers to a collection of one or more entities.

The terms "first," "second," "third," and so forth, as used in the claims, unless otherwise clear by context, is for clarity only and doesn't otherwise indicate or imply any order in time. For instance, "a first determination," "a second determination," and "a third determination," does not indicate or imply that the first determination is to be made before the second determination, or vice versa, etc.

The description of illustrated embodiments of the subject disclosure as provided herein, including what is described in the Abstract, is not intended to be exhaustive or to limit the disclosed embodiments to the precise forms disclosed. While specific embodiments and examples are described herein for illustrative purposes, various modifications are possible that are considered within the scope of such embodiments and examples, as one skilled in the art can recognize. In this regard, while the subject matter has been described herein in connection with various embodiments and corresponding drawings, where applicable, it is to be understood that other similar embodiments can be used or modifications and additions can be made to the described embodiments for performing the same, similar, alternative, or substitute function of the disclosed subject matter without deviating therefrom. Therefore, the disclosed subject matter should not be limited to any single embodiment described herein, but rather should be construed in breadth and scope in accordance with the appended claims below.
**The following is a list of further preferred embodiments of the invention:**
Embodiment 1. A system, comprising:
   a vertical-cavity surface-emitting laser (VCSEL) die positioned perpendicular to an optical axis of a lens, the VCSEL die comprising respective emitter elements positioned within respective spatial zones of an emission surface of the VCSEL die, wherein a distance between the lens and the emission surface of the VCSEL die differs from a focal length of the lens by at least a threshold amount;
   a diffuser object situated opposite the VCSEL die with respect to the lens, resulting in an optical path of light emitted from the VCSEL die passing through the lens and the diffuser object;
   a controller that selects emitter elements, of the of the emitter elements and positioned within respective selected spatial zone of the spatial zones, based on an intended angular beam width of light to be emitted from the system, resulting in selected emitter elements; and
   a driver system that selectively applies a drive signal to the selected emitter elements in response to the selected emitter elements being selected by the controller.
Embodiment 2. The system of embodiment 1, wherein respective ones of the emitter elements respectively comprise one or more lasing segments etched into the emission surface of the VCSEL die.
Embodiment 3. The system of embodiment 1, wherein the spatial zones occupy mutually exclusive areas of the emission surface of the VCSEL die.
Embodiment 4. The system of embodiment 1, wherein the controller selects, as the selected emitter elements, a group of emitter elements that are positioned within respective ones of a defined number of the spatial zones, the defined number of the spatial zones being determined based on the target angular beam width of the light to be emitted from the system.
Embodiment 5. The system of embodiment 1, wherein the controller selects the selected emitter elements based on a selection input provided to the controller.
Embodiment 6. The system of embodiment 1, wherein the selected emitter elements are first selected emitter elements, and wherein the controller selects second selected emitter elements of the emitter elements and unselects the first selected emitter elements, resulting in shifting an active area of the emission surface of the VCSEL die from a first area to a second area that is at least partially different from the first area.
Embodiment 7. The system of embodiment 1, wherein the drive signal is a pulse width modulated signal, and wherein the driver system sets a duty cycle of the pulse width modulated signal based on a difference between a rated output power of the VCSEL die and a selected average output power level of the VCSEL die.
Embodiment 8. The system of embodiment 1, wherein the spatial zones occupy respective concentric circular regions of the emission surface of the VCSEL die.
Embodiment 9. A system, comprising:
   a vertical-cavity surface-emitting laser (VCSEL) die, the VCSEL die comprising VCSEL emitters arranged on respective regions of an emission surface of the VCSEL die, the VCSEL emitters comprising respective groups of one or more lasing segments etched into the emission surface of the VCSEL die;
   an optics system situated within an optical path of light emitted from the emission surface of the VCSEL die, the optics system comprising a lens and a diffractive optical element situated opposite the VCSEL die with respect to the lens, wherein a distance between the lens and the VCSEL die differs from a focal length of the lens by at least a threshold amount; and
   a control system that energizes selected ones of the VCSEL emitters based on a selection input, resulting in selected VCSEL emitters and causing light emitted from the selected VCSEL emitters to leave the optics system at an intended angular beam width associated with the selection input.
Embodiment 10. The system of embodiment 9, wherein the lens is a first lens, wherein the optics system further comprises a second lens, and wherein the VCSEL emitters comprise:
   first groups of the VCSEL emitters positioned within a first portion of the emission surface of the VCSEL die that is orthogonal to a first optical axis of the first lens; and
   second groups of the VCSEL emitters positioned within a second portion of the emission surface of the VCSEL die that is orthogonal to a second optical axis of the second lens.
Embodiment 11. The system of embodiment 10, wherein the selected VCSEL emitters are of a selected group of the VCSEL emitters, the selected group being selected from the first groups of the VCSEL emitters and the second groups of the VCSEL emitters.
Embodiment 12. The system of embodiment 11, wherein the selected group of the VCSEL emitters is a first selected group, and wherein the control system selects a second selected group of the VCSEL emitters, selected from the first groups of the VCSEL emitters and the second groups of the VCSEL emitters, and unselects the first selected group of the VCSEL emitters, resulting in shifting an active area of the emission surface of the VCSEL die from a first area to a second area that is at least partially different from the first area.
Embodiment The system of embodiment 10, wherein the first lens has a first focal length, and wherein the second lens has a second focal length that is not the first focal length.
Embodiment 14. A method, comprising:
   selecting, by a system comprising a processor, one or more elements from elements of a vertical-cavity surface-emitting laser (VCSEL) die of an illuminator device based on a selection input, resulting in one or more selected elements of the VCSEL array, wherein the selection input is indicative of a selectable angular beam width of light to be emitted from the illuminator device; and
   driving, by the system, the one or more selected elements of the VCSEL array, resulting in the one or more selected elements of the VCSEL array emitting the light through a lens and a diffuser, wherein the lens is positioned at a distance from the VCSEL array that differs from a focal length of the lens, and further resulting in the light being emitted from the illuminator device at the angular beam width.
Embodiment 15. The method of embodiment 14, wherein the elements of the VCSEL die respectively comprise one or more VCSEL emitter segments designed to cause emitted light to demonstrate a level of speckle in downrange illumination after the emitted light traverses an optical path imposing a first amount of defocus and a second amount of diffusion.
Embodiment 16. The method of embodiment 14, wherein the elements of the VCSEL die respectively comprise one or more VCSEL emitter segments designed to cause emitted light to demonstrate a level of brightness in downrange illumination after the emitted light traverses an optical path imposing a first amount of defocus and a second amount of diffusion.
Embodiment 17. The method of embodiment 14, wherein the angular beam width is a first angular beam width, and wherein the selecting comprises selecting a first element of the elements of the VCSEL array in response to the selection input being indicative of the first angular beam width.
Embodiment 18. The method of embodiment 17, wherein the selection input is a first selection input, and wherein the method further comprises:
   selecting, by the system, the first element of the VCSEL array and a second element of the VCSEL array based on a second selection input, the second selection input being indicative of a second angular beam width that is different from the first angular beam width.
Embodiment 19. The method of embodiment 17, wherein the VCSEL array is a first VCSEL array, wherein the lens is a first lens, wherein the diffuser is a first diffuser, wherein the optical path is a first optical path, wherein the elements of the first VCSEL array are first elements, wherein the selection input is a first selection input, and wherein the method further comprises:
   selecting, by the system, one or more second elements of a second VCSEL array, of the illuminator device and not the first VCSEL array, based on a second selection input, resulting in one or more selected second elements of the second VCSEL array, wherein the second selection input is indicative of a second angular beam width, different from the first angular beam width, of the light to be emitted from the illuminator device; and
   driving, by the system, the one or more selected second elements of the second VCSEL array, resulting in the one or more selected second elements of the second VCSEL array emitting the light through a second lens and a second diffuser in a second optical path of the second VCSEL array, the second lens and the second diffuser causing the light to be emitted from the illuminator device at the second angular beam width.
Embodiment 20. The method of embodiment 19, wherein the focal length of the first lens is a first focal length, and wherein the second lens has a second focal length that is not the first focal length.

## Claims

1. A system, comprising:
a vertical-cavity surface-emitting laser (VCSEL) die positioned perpendicular to an optical axis of a lens, the VCSEL die comprising respective emitter elements positioned within respective spatial zones of an emission surface of the VCSEL die, wherein a distance between the lens and the emission surface of the VCSEL die differs from a focal length of the lens by at least a threshold amount;
a diffuser object situated opposite the VCSEL die with respect to the lens, resulting in an optical path of light emitted from the VCSEL die passing through the lens and the diffuser object;
a controller that selects emitter elements, of the of the emitter elements and positioned within respective selected spatial zone of the spatial zones, based on an intended angular beam width of light to be emitted from the system, resulting in selected emitter elements; and
a driver system that selectively applies a drive signal to the selected emitter elements in response to the selected emitter elements being selected by the controller.

2. The system of claim 1, wherein respective ones of the emitter elements respectively comprise one or more lasing segments etched into the emission surface of the VCSEL die.

3. The system of claim 1 or 2, wherein the spatial zones occupy mutually exclusive areas of the emission surface of the VCSEL die.

4. The system of one of claims 1 to 3, wherein the controller selects, as the selected emitter elements, a group of emitter elements that are positioned within respective ones of a defined number of the spatial zones, the defined number of the spatial zones being determined based on the target angular beam width of the light to be emitted from the system; or
wherein the controller selects the selected emitter elements based on a selection input provided to the controller.

5. The system of one of claims 1 to 4, wherein the selected emitter elements are first selected emitter elements, and wherein the controller selects second selected emitter elements of the emitter elements and unselects the first selected emitter elements, resulting in shifting an active area of the emission surface of the VCSEL die from a first area to a second area that is at least partially different from the first area.

6. The system of one of claims 1 to 5, wherein the drive signal is a pulse width modulated signal, and wherein the driver system sets a duty cycle of the pulse width modulated signal based on a difference between a rated output power of the VCSEL die and a selected average output power level of the VCSEL die; or
wherein the spatial zones occupy respective concentric circular regions of the emission surface of the VCSEL die.

7. A system, comprising:
a vertical-cavity surface-emitting laser (VCSEL) die, the VCSEL die comprising VCSEL emitters arranged on respective regions of an emission surface of the VCSEL die, the VCSEL emitters comprising respective groups of one or more lasing segments etched into the emission surface of the VCSEL die;
an optics system situated within an optical path of light emitted from the emission surface of the VCSEL die, the optics system comprising a lens and a diffractive optical element situated opposite the VCSEL die with respect to the lens, wherein a distance between the lens and the VCSEL die differs from a focal length of the lens by at least a threshold amount; and
a control system that energizes selected ones of the VCSEL emitters based on a selection input, resulting in selected VCSEL emitters and causing light emitted from the selected VCSEL emitters to leave the optics system at an intended angular beam width associated with the selection input.

8. The system of claim 7, wherein the lens is a first lens, wherein the optics system further comprises a second lens, and wherein the VCSEL emitters comprise:
first groups of the VCSEL emitters positioned within a first portion of the emission surface of the VCSEL die that is orthogonal to a first optical axis of the first lens; and
second groups of the VCSEL emitters positioned within a second portion of the emission surface of the VCSEL die that is orthogonal to a second optical axis of the second lens.

9. The system of claim 8, wherein the selected VCSEL emitters are of a selected group of the VCSEL emitters, the selected group being selected from the first groups of the VCSEL emitters and the second groups of the VCSEL emitters; and/or
wherein the selected group of the VCSEL emitters is a first selected group, and wherein the control system selects a second selected group of the VCSEL emitters, selected from the first groups of the VCSEL emitters and the second groups of the VCSEL emitters, and unselects the first selected group of the VCSEL emitters, resulting in shifting an active area of the emission surface of the VCSEL die from a first area to a second area that is at least partially different from the first area.

10. The system of claim 8 or 9, wherein the first lens has a first focal length, and wherein the second lens has a second focal length that is not the first focal length.

11. A method, comprising:
selecting, by a system comprising a processor, one or more elements from elements of a vertical-cavity surface-emitting laser (VCSEL) die of an illuminator device based on a selection input, resulting in one or more selected elements of the VCSEL array, wherein the selection input is indicative of a selectable angular beam width of light to be emitted from the illuminator device; and
driving, by the system, the one or more selected elements of the VCSEL array, resulting in the one or more selected elements of the VCSEL array emitting the light through a lens and a diffuser, wherein the lens is positioned at a distance from the VCSEL array that differs from a focal length of the lens, and further resulting in the light being emitted from the illuminator device at the angular beam width.

12. The method of claim 11, wherein the elements of the VCSEL die respectively comprise one or more VCSEL emitter segments designed to cause emitted light to demonstrate a level of speckle in downrange illumination after the emitted light traverses an optical path imposing a first amount of defocus and a second amount of diffusion.

13. The method of claim 14, wherein the elements of the VCSEL die respectively comprise one or more VCSEL emitter segments designed to cause emitted light to demonstrate a level of brightness in downrange illumination after the emitted light traverses an optical path imposing a first amount of defocus and a second amount of diffusion.

14. The method of one of claims 11 to 13, wherein the angular beam width is a first angular beam width, and wherein the selecting comprises selecting a first element of the elements of the VCSEL array in response to the selection input being indicative of the first angular beam width; and/or
wherein the selection input is a first selection input, and wherein the method further comprises:
selecting, by the system, the first element of the VCSEL array and a second element of the VCSEL array based on a second selection input, the second selection input being indicative of a second angular beam width that is different from the first angular beam width.

15. The method of claim 14, wherein the VCSEL array is a first VCSEL array, wherein the lens is a first lens, wherein the diffuser is a first diffuser, wherein the optical path is a first optical path, wherein the elements of the first VCSEL array are first elements, wherein the selection input is a first selection input, and wherein the method further comprises:
selecting, by the system, one or more second elements of a second VCSEL array, of the illuminator device and not the first VCSEL array, based on a second selection input, resulting in one or more selected second elements of the second VCSEL array, wherein the second selection input is indicative of a second angular beam width, different from the first angular beam width, of the light to be emitted from the illuminator device; and
driving, by the system, the one or more selected second elements of the second VCSEL array, resulting in the one or more selected second elements of the second VCSEL array emitting the light through a second lens and a second diffuser in a second optical path of the second VCSEL array, the second lens and the second diffuser causing the light to be emitted from the illuminator device at the second angular beam width; and/or wherein the focal length of the first lens is a first focal length, and wherein the second lens has a second focal length that is not the first focal length.
